Europäisches Patentamt

European Patent Office

Office européen des brevets

(11) Publication number: **0 382 558**
**A1**

## EUROPEAN PATENT APPLICATION

(21) Application number: **90301399.3**

(51) Int. Cl.5: **H01B 7/08, H01P 3/08**

(22) Date of filing: **09.02.90**

(30) Priority: **10.02.89 JP 34324/89**

(43) Date of publication of application:
**16.08.90 Bulletin 90/33**

(84) Designated Contracting States:
**AT BE CH DE DK ES FR GB GR IT LI LU NL SE**

(71) Applicant: **JUNKOSHA CO. LTD.**
**25-25, Miyasaka 2-chome**
**Setagaya-ku Tokyo 156(JP)**

(72) Inventor: **Suzuki, Masahiro**
**102 Junnes-Ishida, 853-6 Kami-Arai**
**Tokorozawa-shi, Saitama(JP)**

(74) Representative: **Foster, David Martyn et al**
**MATHISEN MACARA & CO. The Coach**
**House 6-8 Swakeleys Road**
**Ickenham Uxbridge UB10 8BZ(GB)**

(54) **Strip line cable.**

(57) A strip line cable has a pair of conductors (6,8) disposed on opposite sides of a dielectric layer (2) of porous, expanded polytetrafluoroethylene. The cable has a reinforcing layer (4) of a non-porous plastics material positioned between the conductors, either adjacent one of the conductors (6) or embedded within the porous dielectric layer (2).

_Fig.1._

EP 0 382 558 A1

## STRIP LINE CABLE

This invention relates to a strip line cable suitable for the transmission of microwaves, and in particular, a strip line cable in which a signal conductor and a ground conductor are each placed on opposite sides of a dielectric layer in the form of a narrow strip.

In recent years, strip lines have tended to be lighter and less bulky than coaxial cables due to their much lower transmission attenuation. In particular, they have become important as a means for transmitting microwaves. For example, Japanese Laid-Open Patent Registration No. 63-12563 in the name of applicant, discloses such a strip line. The strip line cable disclosed in that reference has a structure comprising at least one set of conductors placed longitudinally on opposite surfaces of an elongate dielectric layer made of porous, expanded polytetrafluoroethylene (PTFE), and the surfaces of the dielectric layer on which the conductors are placed are covered by a layer of a non-porous plastics material. The coating of non-porous plastics material maintains a good microwave transmission characteristic, and also functions as a hard, stabilizing layer, giving reinforcement to the flexible layer of porous PTFE material.

However, known strip line cables, as described above, were developed particularly for transmission at high frequency and the dielectric layer is purposely made thin (for example, 0.127 mm) in order to keep the size and weight of the cables small. Consequently, the characteristic impedance of the dielectric layer is low, resulting in a comparatively high signal attenuation.

While it is easy to imagine that the thickness of the dielectric layer could be increased so as to reduce the attenuation, the workable length of such a cable, produced by existing press-working devices, would be limited to about 1 metre, for example, in order to maintain a balance in the production devices. The characteristic impedance of the cable would be irregular due to small variations in thickness along its length. Moreover, by simply increasing the thickness of the dielectric, extended-length processing by reel-winding becomes difficult, and it is virtually impossible to maintain a constant spacing between opposite surfaces of the dielectric layer due to the pliancy of the porous PTFE, and this results in a non-uniform characteristic impedance, as described above.

There has been a demand in recent years for strip lines which enable signals to be transmitted and received between lines, without making contact with the lines, at positions freely selected along the length of the line. That is, electro- magnetic waves which leak from the cable when a signal is being transmitted between the conductors can be received by a receiving sensor located near to the lines. When signals are transmitted, a transmitter would be located near the cable, and a signal would be transmitted between the conductors due to the interaction of the electromagnetic waves emitted by the transmitter.

However, it has been difficult to respond to this demand using the afore-mentioned existing strip line cables. This is because such existing strip line cables have very thin conductors and so attenuation is high, and there are relatively few electrical field lines passing out of the line and between the conductors.

It is an object of the present invention to provide a strip line cable which enables signals to be transmitted and received without making contact with the cable, in which there is low attenuation, the impedance along the line is uniform, and in which an existing flexibility is maintained.

According to the invention, there is provided a strip line cable comprising a pair of conductors disposed on opposite sides of a porous, expanded polytetrafluoroethylene dielectric layer and having a reinforcing layer of a non-porous plastics material disposed between the conductors.

In one embodiment of the invention, there is provided a strip line cable comprising a pair of conductors disposed on opposite sides of a porous, expanded polytetrafluoroethylene dielectric layer and having a reinforcing layer of a non-porous plastics material positioned between said dielectric layer and one of said conductors.

In another embodiment of the invention, there is provided a strip line cable comprising a pair of conductors disposed on opposite sides of a porous, expanded polytetrafluoroethylene dielectric layer, said dielectric layer having a reinforcing layer of a non-porous plastics material embedded within it between said conductors.

The non-porous plastics material is preferably a polyimide.

In a preferred embodiment of the invention a strip line cable is provided in which a pair of conductors is placed on opposite sides of a dielectric layer of porous, expanded polytetrafluoroethylene. Also provided in the cable is a reinforcing layer of a non-porous plastics material positioned between the conductors, either adjacent one of the conductors or embedded within the porous dielectric layer.

More specifically, according to this invention, a pair of conductors are each placed on opposite sides of a dielectric layer made of expanded, porous polytetrafluoroethylene (PTFE) in the form of a long narrow strip and a reinforcing layer formed of a non-porous plastics material is set inside the dielectric layer or between the dielectric layer and the conductors. It is preferred that the pair of conductors be covered with a plastics outer coating layer, and that the covering layer coating the conductor used for the line signal be made of expanded, porous polytetrafluoroethylene.

With a strip line cable, as defined herein, electromagnetic waves can propagate along the length of the line between a pair of conductors, the signal conductor, on the one hand, and the ground conductor on the other, while adopting a TEM mode, for example. Because the dielectric between the two conductors is formed of porous PTFE, the dielectric constant and dielectric loss are low and their frequency dependency is low, so that transmission characteristics are relatively good. Even when the dielectric is made comparatively thick, impedance is increased and the amount of attenuation is reduced, and because the reinforcing layer is formed of a non-porous plastics material and is suitably rigid, the excessive flexibility of the dielectric is controlled and the spacing between conductors can be maintained constant. Accordingly, both a reduction in attenuation and uniformity of characteristic impedance can be established. By adjusting the thickness of the dielectric layer to a value suitable to achieve a desired attenuation, flexibility can be maintained.

The conductors are insulated by being covered by the coating layer. If the coating layer is formed of porous PTFE, there is less dielectric loss than when other plastics materials, such as polyethylene, are used, and the transmission characteristics are improved.

Strip line cables in accordance with the invention are now described, by way of example only, with reference to the accompanying drawings in which:

Figure 1 shows a perspective cross-sectional view of one embodiment of a strip line cable according to the invention;

Figure 2 shows a graph illustrating TDR waves as a function of time in nano-seconds in the cable of Figure 1; and

Figure 3 shows a cross-sectional view through another embodiment of a cable according to the invention.

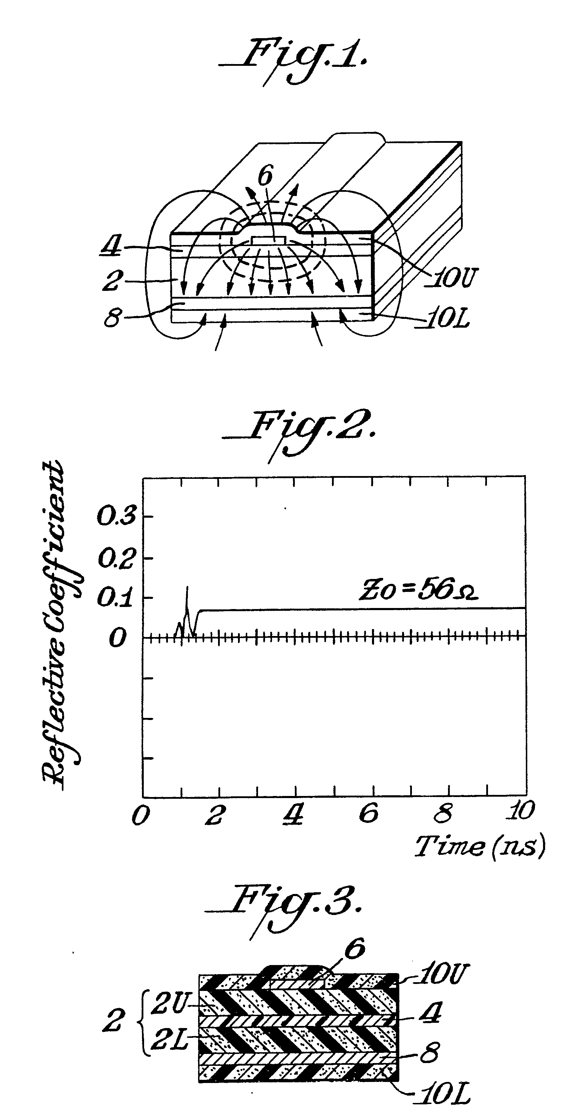

Figure 1 shows a strip line cable used as a cable. The cable width is 10 mm.

The strip line cable comprises a relatively thick dielectric layer 2. In this example, the layer 2 is 0.8 mm thick and is made from porous PTFE (having a relative permittivity of approximately 1.3). As shown in Figure 1, a reinforcing layer 4 in the form of a thin sheet made from a non-porous plastics material is provided on the upper surface of layer 2. In this example, the reinforcing layer 4 is 0.2 mm thick and is formed from a polyimide resin (having a relative permittivity of approximately 3.4), so that it functions as a rigid, sheet-like material. Other suitable, similar plastics materials may be used. That is, the excessive flexibility of the dielectric layer 2 formed from the porous PTFE is controlled, and the shape of the dielectric portion is stabilized.

A signal line conductor 6 comprising a straight, silver-plated flexible copper wire (0.1 mm thick and 1.5 mm wide) is fixed centrally to the upper surface of the reinforcing layer 4 and extends lengthwise thereof, as shown, and a ground line conductor 8 formed from rolled copper foil (0.035 mm thick and 10 mm wide) is fixed to the bottom surface of the dielectric layer 2. Coating layers 10U and 10L formed from porous PTFE (0.1 mm thick) adhere respectively to the upper surface of the signal line conductor 6 and the exposed surfaces of reinforcing layer 4 and the bottom surface of the ground conductor 8.

The layered structure, thus described, is formed into a single body by assembling each of the prepared tape materials in the correct sequence and causing them to adhere by passing them through a heated roller apparatus.

Due to the high dielectric constant of the reinforcing layer 4, the combined dielectric constant of the insulating portion between the conductors 6 and 8 is slightly higher than the dielectric constant of the dielectric layer 2 alone ( $\approx 1.3$ ), but has a value much less than that of non-porous materials such as polyethylene.

Therefore microwaves fed into the line will, at the moment its dielectric field components appear, be distributed between the signal line conductor 6 and the ground conductor 8, as represented by the solid line arrows in Figure 1, and will propagate in a lengthwise direction, whereas the magnetic field components adopt a set mode, as represented by the broken line arrows in the same figure, being distributed orthogonally with respect to the electric field components. Because the combined dielectric constant and dielectric loss of dielectric layer 2 and the reinforcing layer 4 portions are lower than those of a non-porous plastics material, a desired microwave transmission characteristic can be obtained. Because the dielectric 2 is flexible, the entire structure can be made with a desired amount of flexibility.

As described above, by stabilizing the dielectric layer 2 using the reinforcing layer 4, a near constant separation can be maintained between conductors 6 and 8 along the entire length of the cable, and so the characteristic impedance $Z_0$, which is determined by the separation between conductors 6 and 8, is maintained at an almost constant value along the length of the cable. In order to confirm this fact, the TDR (time-domain reflection) wave form in the layered structure described with reference to Figure 1 was measured, and, as shown in Figure 2, it was found to have a nearly constant reflection coefficient, namely, a nearly constant characteristic impedance (= 56 ohms). The initial irregular waveform in Figure 2 is the result of excessive development.

Because the dielectric layer 2 can be made thicker than previous materials, and the value of the characteristic impedance, which can be maintained at a constant level as explained above, can be increased, signal attenuation from this surface can be maintained at a low level. In this connection, the amount of reflection attenuation, in this example, in the frequency range from 0.1 GHz to 1.1 GHz was found on average to be approximately 28 dB, and the insertion loss was approximately 1-3 dB/5m in the same frequency range, characteristics which are very favourable.

The thicker the dielectric layer, the higher will be the attenuation, and there will be a greater number of electric field lines passing out of the line from conductors 6 and 8. By placing the transmitter/ receiver of a microwave transmitting/receiving device in proximity to conductor 6 on the strip line cable at a desired, selected position along its length, without contacting the cable, signals can be transmitted and received at that position.

Because the coating layers 10U and 10L, which coat conductors 6 and 8, are made from a porous PTFE, which has a small relative permittivity, compared with that of a non-porous plastics material, the attenuation of the electric field components emitted from and irradiated into the upper surface of conductor 6 can be reduced. By these means, the electric field components circulating outside the cable can be increased, and the transmission and reception of signals, without contact, as described previously, becomes easier.

In a second embodiment of the invention, shown in Figure 3, the dielectric layer 2 is divided into an upper portion 2U and a lower portion 2L, and the reinforcing layer 4 is located between these two layers. In other respects, the structures shown in Figures 1 and 3 are similar.

Accordingly, the structure shown in Figure 2 has the same attributes as that shown in Figure 1. Moreover, since the dielectric layer 2 is supported centrally by the reinforcing layer 4, the reinforcing effect of the latter is enhanced, allowing a more uniform separation between the conductors 6 and 8 to be maintained, and so the characteristic impedance along the length of the cable is more precisely uniform. Consequently, the thickness of the dielectric layer 2 can be further increased, having the concomitant effect of further reducing the amount of attenuation. In this way, the structure shown in Figure 3 is more advantageous when, as previously described, the transmission and reception of a signal is performed without line contact, since the thickness of the dielectric 2 can be greater.

In both of the above embodiments, the coating layers 10U and 10L covering conductors 6 and 8 are made from porous PTFE, but the present invention is not restricted to that material, and, as necessary, it is possible to use a non-porous material with slightly lower relative permittivity, such as polyethylene. In that case, there is the additional advantage of an enhanced form-stabilization. Alternatively, in order to simplify the structure, the coating layers 10U and 10L could be omitted.

In both of the above embodiments, the strip line is produced as a cable, but may be used as a high-frequency transmission line employing a substrate in which the ground conductor 8 is formed as a substrate conductor.

Moreover, the dimensions and shapes of the dielectric layer 2 and the reinforcing layer 4 are not limited to those previously described. Other dimensions are possible. For example, the cross-sectional shape of the signal conductor line 6 may be round. Of course, the position of the reinforcing layer 4 is not restricted to those given in the illustrated embodiments. Layer 4 may, for example, be located in upper or lower regions of dielectric layer 2, as desired, or it may be located between the dielectric layer 2 and the ground conductor 8.

As explained above, by means of the present invention, because the dielectric material separating the two conductors used for signal transmission is formed of porous PTFE, and a reinforcing layer formed of a non-porous plastics material is embedded within this dielectric material or so that it is in contact with the dielectric, and due to the fact that the dielectric constant and the dielectric loss of the porous PTFE, which is the major component material, are small, and also the fact that the frequency dependency of these materials is low, excellent transmission characteristics can be maintained. Even when the dielectric layer is relatively thick and the attenuation is thereby decreased, because the reinforcing layer is rigid and relatively stiff, a uniform spacing can be maintained between the conductors along the length of the cable. Accordingly, a reduced attenuation and a more uniform characteristic impedance can be achieved simultaneously. By adjusting the thickness of the dielectric layer so that there is a suitable correspondence to the amount of attenuation, flexibility can be maintained.

As discussed above, in a condition in which the dielectric thickness is increased (that is, a condition of low attenuation and uniform characteristic impedance), because the electric field lines leaking from the line and passing between the conductors increases, it is possible to transmit and receive signals, without contact with the line, at a chosen position along its length.

Also, the conductors can be protected by provision of a coating layer which covers both conductors. When the coating layer is formed of porous PTFE, more electric field components are able to leak from the line than is possible with other plastics materials, thus making the transmission and reception of signals easier, without contacting the line. The transmission characteristics are thereby improved.

## Claims

1. A strip line cable comprising a pair of conductors (6,8) disposed on opposite sides of a porous, expanded polytetrafluoroethylene dielectric layer (2) and having a reinforcing layer (4) of a non-porous plastics material disposed between the conductors (6,8).

2. A strip line cable comprising a pair of conductors (6,8) disposed on opposite sides of a porous, expanded polytetrafluoroethylene dielectric layer (2) and having a reinforcing layer (4) of a non-porous plastics material positioned between said dielectric layer and one of said conductors (6,8).

3. A strip line cable comprising a pair of conductors (6,8) disposed on opposite sides of a porous, expanded polytetrafluoroethylene dielectric layer (2), said dielectric layer (2) having a reinforcing layer (4) of a non-porous plastics material embedded within it between said conductors (6,8).

4. A strip line cable as claimed in any one of claims 1 to 3, wherein said non-porous plastics material is a polyimide.

5. A strip line cable as claimed in any one of claims 1 to 4, wherein each conductor is covered by a respective layer (10U,10L) of a plastics material.

6. A strip line cable as claimed in claim 5, wherein the layer (10U,10L) covering each conductor is made from expanded porous PTFE.

*Fig.1.*

*Fig.2.*

$Z_0 = 56\,\Omega$

Reflective Coefficient

Time (ns)

*Fig.3.*

| | DOCUMENTS CONSIDERED TO BE RELEVANT | | EP 90301399.3 |
| --- | --- | --- | --- |
| Category | Citation of document with indication, where appropriate, of relevant passages | Relevant to claim | CLASSIFICATION OF THE APPLICATION (Int. Cl.⁵) |
| X;Y | EP - A2 - 0 204 446 (JUNKOSHA) * Abstract; column 7, lines 27-34; column 7, line 50 - column 8, line 4; fig. 7,10 * | 1-3,5; 4 | H 01 B 7/08 H 01 P 3/08 |
| Y | US - A - 4 798 918 (KABADI et al.) * Column 2, lines 49-56; fig. 3 * | 4 | |
| X | US - A - 4 639 693 (SUZUKI et al.) * Abstract; column 3, lines 26-33; column 4, lines 28-36; fig. 5 * | 1,2,5, 6 | |
| A | GB - A - 2 075 744 (JUNKOSHA) * Abstract; fig. 1-5 * ---- | 1 | TECHNICAL FIELDS SEARCHED (Int Cl.⁵) H 01 B 7/00 H 01 P 3/00 |

The present search report has been drawn up for all claims

| Place of search | Date of completion of the search | Examiner |
| --- | --- | --- |
| VIENNA | 26-04-1990 | KUTZELNIGG |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82